# EUROPEAN PATENT APPLICATION

(11) **EP 4 270 027 A1**
(43) Date of publication of application: **01.11.2023**
(21) Application number: 21960254.7
(22) Date of filing: 14.10.2021
(51) Int. Cl.: G01R 31/36, G01R 31/52

(54) **DETECTION METHOD FOR BATTERY, DETECTION DEVICE, BATTERY MANAGEMENT SYSTEM, AND STORAGE MEDIUM**

(71) Applicant: Contemporary Amperex Technology Co., Limited, Fujian PRC 352100 (CN)
(72) Inventor: XIE, Lan, Ningde, Fujian 352100 (CN); LIN, Zhen, Ningde, Fujian 352100 (CN); HUANG, Shan, Ningde, Fujian 352100 (CN); LI, Wei, Ningde, Fujian 352100 (CN); LI, Zhonghong, Ningde, Fujian 352100 (CN)
(74) Representative: Feira, Edoardo
(86) International application number: PCT/CN2021/123917
(87) International publication number: WO 2023/060518

(57) **Abstract**

Embodiments of the present application provide a detection method and detection device for a battery, a battery management system, and a storage medium, which can easily and accurately detect an internal short circuit in a battery and give a warning. The method includes: acquiring a current voltage of a battery; sending a charging request to a charging device, the charging request including a requested voltage, the charging request being used to request the charging device to output the requested voltage to the battery, where the requested voltage is smaller than the current voltage; acquiring a current of the battery within a duration in which the charging device outputs the requested voltage to the battery; and determining an internal short circuit condition of the battery according to the current.

## Description

### TECHNICAL FIELD

The present application relates to the field of battery technologies, in particular to a detection method and detection device for a battery, a battery management system, and a storage medium.

### BACKGROUND

With the rapid development of new energy batteries, the safety performance of a battery is an important factor related to its development, especially when the battery is short-circuited, it often causes safety accidents, which affects the development and application of battery-related products. At present, a method of comparing a collected characteristic parameter of a battery with a preset value is usually used to identify whether an internal short circuit occurs in the battery, however, when the specific value of the characteristic parameter is collected, excess errors often occur, resulting in low precision of recognition of the internal short circuit in the battery and inaccurate detection results.

### SUMMARY

Embodiments of the present application provide a detection method and detection device for a battery, a battery management system, and a storage medium, which can accurately detect an internal short circuit in a battery.

In a first aspect, the present application provides a detection method for a battery, including: acquiring a current voltage of the battery; sending a charging request to a charging device, the charging request including a requested voltage, the charging request being used to request the charging device to output the requested voltage to the battery, where the requested voltage is smaller than the current voltage; acquiring a current of the battery within a duration in which the charging device outputs the requested voltage to the battery; and determining an internal short circuit condition of the battery according to the current.

A detection method for a battery can be realized by embodiments of the present application. A current voltage of the battery is adjusted to a requested voltage slightly lower than the current voltage, and a current of the battery varies accordingly. Since a battery in which an internal short circuit occurs and a battery in which an internal short circuit does not occur are different for current response generated by variation of a charging voltage, it is possible to detect whether the battery has an internal short circuit only through variation of the current, without obtaining the precise value of a parameter, which makes the detection of the internal short circuit in the battery easier and more accurate.

In a possible embodiment, the charging request further includes the duration.

In the foregoing embodiment, while the charging voltage is requested, a duration is preset for the requested voltage. The current of the battery can, within the duration, vary accordingly according to the internal short circuit condition, so as to ensure that the current has enough time for current variation. Thus, the precision of acquisition of the current variation is higher and misjudgment can be avoided.

In a possible embodiment, according to the current, the determining the internal short circuit condition of the battery according to the current includes: determining that the battery does not have an internal short circuit when the current of the battery is not a positive value at the end of the duration; or determining that the battery has an internal short circuit when the current of the battery is a positive value within the duration.

In the foregoing embodiment, the positive and negative values of the current of the battery are acquired within the duration of the requested voltage. When the current of the battery is always a negative value within the duration of the requested voltage, it indicates that the battery has no leakage current, and it can be determined that the battery does not have an internal short circuit; and when the current of the battery is a positive value within the duration, it indicates that the battery has a leakage current, and it can be determined that the battery has an internal short circuit. The internal short circuit condition of the battery can be determined only by acquiring the positive and negative values of the current of the battery within the duration of the requested voltage, so that the error of the detection result is smaller and the accuracy is higher, thereby making a warning signal of the battery short circuit more reliable.

In a possible embodiment, the requested voltage is smaller than the current voltage by 0.1 to 100 millivolts.

In the foregoing embodiments, the requested voltage is set to be smaller than the current voltage by 0.1 to 100 millivolts, so that the voltage of the battery drops slightly, so that a steady current variation occurs in the battery, thereby obtaining the variation of the current more accurately.

In a possible embodiment, a range of the duration is 0.1 minutes to 60 minutes.

In the foregoing embodiments, the acquiring the current voltage of the battery includes: acquiring the current voltage of the battery when the battery is in a state of being connected to a charging device.

In the foregoing embodiments, the detection and warning of the internal short circuit start when the battery is just connected to the charging device, so that the warning can be realized before the battery is charged and the battery can be replaced in time, thereby improving the safety performance.

In a possible embodiment, the acquiring the current voltage of the battery includes: acquiring, in a process of charging the battery, the current voltage of the battery when the charging current is smaller than a current threshold.

In the foregoing embodiment, it is possible to detect and warn the internal short circuit in the battery during or after charging of the battery, timely detect whether the battery has an internal short circuit during charging, which avoids safety accidents caused by the user using the battery in which the internal short circuit occurs after the charging is completed. Thus the safety of the battery is further improved.

In a second aspect, an embodiment of the present application further provides a detection device for a battery, the detection device includes: a processing unit, configured to acquire a current voltage of the battery; a communication unit, configured to send a charging request to a charging device, the charging request including a requested voltage, the charging request being used to request the charging device to output the requested voltage to the battery, where the requested voltage is smaller than the current voltage; where the processing unit is further configured to acquire a current of the battery within a duration in which the charging device outputs the requested voltage to the battery; and the processing unit is further configured to determine an internal short circuit condition of the battery according to the current.

In a possible embodiment, the charging request further includes the duration.

In a possible embodiment, the processing unit is further configured to: determine that the battery does not have an internal short circuit when the current is not a positive value at the end of the duration; or determine that the battery has an internal short circuit when the current is a positive value within the duration.

In a possible embodiment, the requested voltage is smaller than the current voltage by 0.1 to 100 millivolts.

In a possible embodiment, a range of the duration is 0.1 minutes to 60 minutes.

In a possible embodiment, the processing unit is configured to: acquire the current voltage of the battery when the battery is in a state of just being connected to a charging device.

In a possible embodiment, the processing unit is configured to: acquire the current voltage of the battery when the charging current is smaller than a current threshold.

In a third aspect, an embodiment of the present application provides a battery management system, including a processor and a memory, the memory is configured to store a computer program, and the processor is configured to call the computer program to perform the method of the foregoing first aspect or any possible implementation of the first aspect.

In a fourth aspect, an embodiment of the present application provides a readable storage medium, configured to store a computer program, and the computer program is configured to perform the method of the foregoing first aspect or any possible implementation of the first aspect.

### BRIEF DESCRIPTION OF THE DRAWINGS

To describe technical solutions in embodiments of the present application more clearly, the following briefly introduces accompanying drawings required for describing the embodiments of the present application. Apparently, the accompanying drawings in the following description are only some embodiments of the present application, and a person of ordinary skill in the art may still derive other drawings from the accompanying drawings without creative efforts.
FIG. 1 is a schematic structural diagram of a charging system according to an embodiment of the present application;
FIG. 2 is a schematic flow chart of a detection method according to an embodiment of the present application;
FIG. 3 is a schematic diagram of variation of a current versus voltage according to an embodiment of the present application;
FIG. 4 is a schematic diagram of another variation of a current versus voltage according to an embodiment of the present application;
FIG. 5 is a schematic flow chart of another detection method according to an embodiment of the present application; and
FIG. 6 is a schematic structural diagram of a detection device according to an embodiment of the present application.

### DESCRIPTION OF EMBODIMENTS

Implementation manners of the present application will be further described below in detail with reference to accompanying drawings and embodiments. The detailed description of the following embodiments and the accompanying drawings are used to exemplarily illustrate principles of the present application, but cannot be used to limit the scope of the present application, that is, the present application is not limited to the described embodiments.

In the depiction of the present application, it should be noted that, unless otherwise illustrated, "plurality" means two or more; and orientations or positional relationships indicated by terms such as "up", "down", "left", "right", "inner", and "outer" are merely for convenience of describing the present application and simplifying the description, rather than for indicating or implying that an apparatus or element indicated must have a specific orientation, and must be constructed and operated in a specific orientation, which thus shall not be understood as limitation to the present application. In addition, the terms such as "first", "second", and "third" are merely intended for the purpose of description, and shall not be understood as an indication or implication of relative importance.

The orientations phases in the following description are all the directions shown in the drawings, and do not limit the specific structure of the present application. In the description of the present application, it should be further noted that, unless otherwise explicitly specified and defined, terms "installation", "interconnection", and "connection" should be understood in a broad sense; for example, they may be either a fixed connection, or a detachable connection, or an integrated connection; and they may be either a direct connection, or an indirect connection through an intermediate medium. A person of ordinary skill in the art may appreciate the specific meanings of the foregoing terms in the present application according to specific conditions.

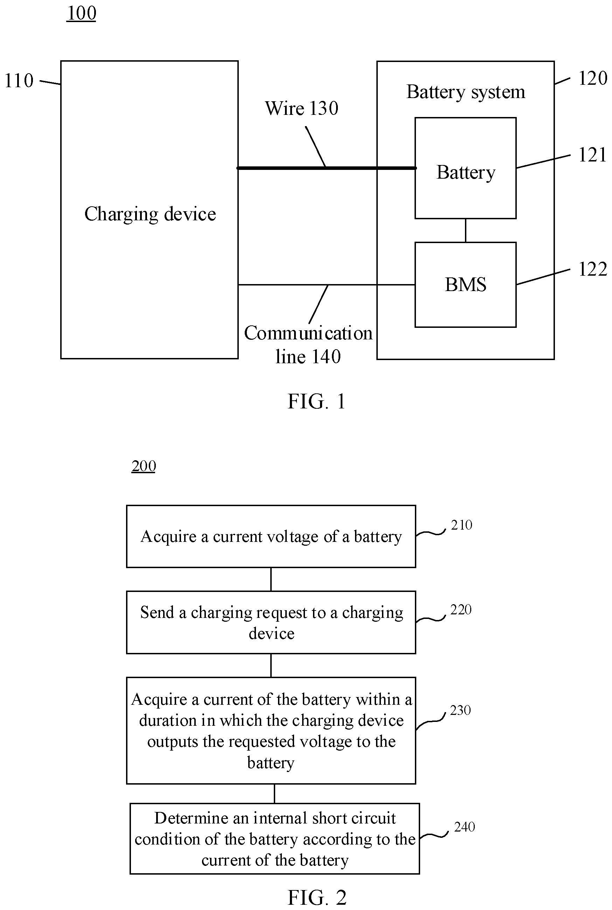

FIG. 1 shows an architectural diagram of a charging system to which embodiments of the present application are applicable.

As shown in FIG. 1, a charging system 100 may include a charging device 110 and a battery system 120. Optionally, the battery system 120 may be a battery system in an electric vehicle (including a pure electric vehicle and a plug-in hybrid electric vehicle) or a battery system in other application scenarios.

Optionally, at least one battery pack (battery pack) may be disposed in the battery system 120, and the entirety of the at least one battery pack may be collectively referred to as a battery 121. In terms of a type of a battery, the battery 121 may be any type of battery, including but not limited to: a lithium ion battery, a lithium metal battery, a lithium sulfur battery, or the like. In terms of a size of a battery, the battery 121 in the embodiment of the present application may be a battery core/battery cell (cell), or a battery module or a battery pack. A battery module or a battery pack may be composed of multiple batteries connected in series and in parallel. In the embodiment of the present application, the specific type and size of the battery 121 are not specifically limited.

In addition, in order to intelligently manage and maintain the battery 121, prevent the battery from overcharging and over-discharging, and prolong the service life of the battery, a battery management system (battery management system, BMS) 122 is generally disposed in the battery system 120 for monitoring the status of the battery 121. Optionally, the BMS 122 and the battery 121 may be integrated and disposed in the same device/apparatus, or the BMS 122 may also be disposed outside the battery 121 as an independent device/apparatus.

Specifically, the charging device 110 is a device for supplementing electric energy for the battery 121 in the battery system 120 and/or controlling the discharging of the battery 121.

Optionally, the charging device 110 in the embodiment of the present application may be a general charging pile, a super charging pile, a charging pile supporting a vehicle to grid (vehicle to grid, V2G) mode, or a charging device capable of charging a battery. The embodiment of the present application does not limit the specific type and specific application scenarios of the charging device 110.

Optionally, as shown in FIG. 1, the charging device 110 may be connected to the battery 121 through a wire 130 and connected to the BMS 122 through a communication line 140, and the communication line 140 is configured to realize information exchange between the charging device 110 and the BMS.

As an example, the communication line 140 includes, but is not limited to, a control area network (control area network, CAN) communication bus or a daisy chain (daisy chain) communication bus.

Optionally, in addition to communicating with the BMS 122 through the communication line 140, the charging device 110 may also communicate with the BMS 122 via a wireless network. The embodiment of the present application does not specifically limit the communication type, either wired or wireless, between the charging and discharging device and the BMS 122.

Most commercial power batteries are rechargeable storage batteries, and the most common ones are lithium batteries, such as lithium ion batteries or lithium ion polymer batteries. During charging, the battery is generally charged in a continuous charging manner, and continuous charging of the battery may cause lithium plating and heat generation of the battery. When lithium plating abundantly occurs in the battery, the lithium dendrites puncture the separator and cause a short circuit in the battery, which not only reduces the battery performance, greatly shortens the cycle life, but also limits the fast charging capacity of the battery, and may cause disastrous consequences such as combustion, explosion, or the like, resulting in serious safety problems.

On the one hand, the currently commonly used detection method of an internal short circuit in a battery is to collect a voltage signal, a temperature signal, or the like of the battery as a warning characteristic parameter of the internal short circuit in the battery, and compare the warning characteristic parameter with a preset threshold, so as to make a warning of the battery short circuit. However, parameters of the battery such as voltage, temperature, or the like fluctuate within a certain range since single battery cores still have discrepancies for the same battery pack, which reduces the accuracy of the collected signal, usually causing a certain degree of misjudgment, and making the detection result of an internal short circuit inaccurate. On the other hand, the current detection system has low recognition precision for voltage, so it is difficult to accurately recognize the voltage variation caused by the short circuit at a level of ohms in the battery core, which also greatly reduces the reliability of detection of the internal short circuit in the battery using this method.

In order to ensure the safety performance of the battery and detect an internal short circuit in a battery more accurately and make a reliable warning, the embodiments of the present application provide a detection method and detection device for an internal short circuit in a battery.

FIG. 2 shows a detection method 200 according to an embodiment of the present application. The method 200 may be performed by a BMS 122 to recognize an internal short circuit condition of a battery 121, and specifically includes some or all of the following steps.

Step 210: acquire a current voltage of a battery.

Step 220: send a charging request to a charging device.

The charging request includes a requested voltage, and is used to request the charging device 110 to output the requested voltage to the battery 121, and the requested voltage is smaller than the current voltage.

The charging request may further include a duration of the requested voltage, and the requested voltage is constant within a preset duration. While the charging voltage is requested, a duration is preset for the requested voltage. The current of the battery 121 can, within the duration, vary accordingly according to the internal short circuit condition, so as to ensure that the current has enough time for the current variation. Thus, the precision of acquisition of the current variation is higher and misjudgment can be avoided.

Step 230: acquire a current of the battery within a duration in which the charging device outputs the requested voltage to the battery.

Step 240: determine an internal short circuit condition of the battery according to the current of the battery.

According to the foregoing embodiments, the internal short circuit condition of the battery is detected by acquiring the current of the battery utilizing the characteristic that the battery in which the internal short circuit occurs has the leakage current.

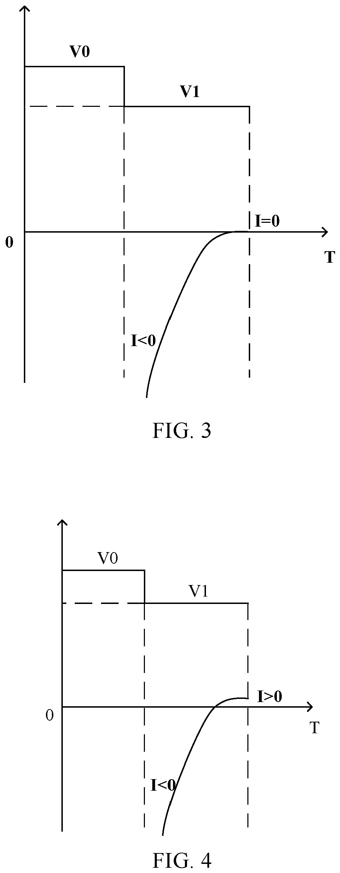

Specifically, the current voltage of the battery is adjusted to be slightly lower than the requested voltage of the current voltage, and when the voltage decreases, the current of the battery varies accordingly, and a battery in which an internal short circuit occurs and a battery in which an internal short circuit does not occur differ in the current variation. As shown in FIG. 3, for a battery in which an internal short circuit does not occur, when the charging voltage decreases from V0 to V1, it has a current response rapidly decayed, and the current of the battery obtained at this time is a negative value (I<0). When the voltage of the battery is correspondingly decreased to an applied charging voltage V1, the current response gradually approaches zero, and the current of the battery obtained at this time is zero (I=0). For a battery in which an internal short circuit occurs, as shown in FIG. 4, when the charging voltage decreases from V0 to V1, it also has a current response rapidly decayed, and the current of the battery obtained at this time is a negative value (I<0). However, when the voltage of the battery is decreased to an applied charging voltage V1, the voltage of the battery continues to drop due to the leakage current of the battery. In order to keep the charging voltage constant, a certain amount of current has to be absorbed from an external circuit to supplement the loss caused by the leakage current, and the current of the battery obtained at this time is a positive value (I>0). Therefore, when the current of the battery 121 is not a positive value at the end of the duration, it is determined that the battery does not have an internal short circuit; and when the current of the battery 121 has a positive value within the duration, it is determined that the battery has an internal short circuit. For the battery in which an internal short circuit occurs, charging is stopped and the battery is returned to the factory. This detection method can recognize whether the battery 121 has an internal short circuit only by acquiring the positive and negative changes in the current of the battery 121 without acquiring specific values of the current or other related parameters, thereby making a process of detecting an internal short circuit in the battery simpler, the error less, and the warning signal of the battery more reliable.

Optionally, the requested voltage is smaller than the current voltage by 0.1 to 100 millivolts. The voltage of the battery is slightly decreased so that a steady current variation occurs in the battery, thereby obtaining the current variation more accurately.

Optionally, a range of the duration is 0.1 minutes to 60 minutes.

The detection method in the foregoing embodiments may be performed when the battery is just connected to the charging device. Specifically, when the battery is just connected to the charging device 110, for example, when a gun is just inserted, the current voltage of the battery 121 is obtained to perform the foregoing internal short circuit detection. At this time, there is no charging current, and after a charging voltage lower than the current voltage is applied, a rapid response of the current of the battery 121 is a negative value, thereby facilitating the foregoing internal short circuit detection.

The detection method according to the foregoing embodiment is performed when the battery is just connected to the charging device, which can detect and warn the internal short circuit condition of the battery before charging and can timely warn the replacement of the battery in which an internal short circuit occurs, thereby avoiding the charging device charging the short-circuited battery and further greatly improving the safety of battery use.

Further, the detection method in the foregoing embodiments may also be performed during charging of the battery, for example, the method is performed when the battery is fully charged or close to being fully charged. Specifically, when the charging current is smaller than a preset current threshold, the current voltage of the battery 121 is acquired. At this time, the charging current is very small, and after a charging voltage lower than the current voltage is applied, a rapid response of the current of the battery 121 is a negative value, thereby facilitating the foregoing internal short circuit detection. It should be understood that, except a case where the battery is fully charged or close to being fully charged, the internal short circuit detection may also be performed by controlling the charging current to be smaller than a preset current threshold during charging, which is not limited in this embodiment of the present application.

The detection method according to the foregoing embodiments is performed during the charging of a battery, so that it is possible to detect and warn the internal short circuit in the battery in a process of or after charging the battery, timely detect whether the battery has an internal short circuit during charging, which avoids safety accidents caused by the user using the battery in which the internal short circuit occurs after the charging is completed. Thus the safety of the battery is further improved.

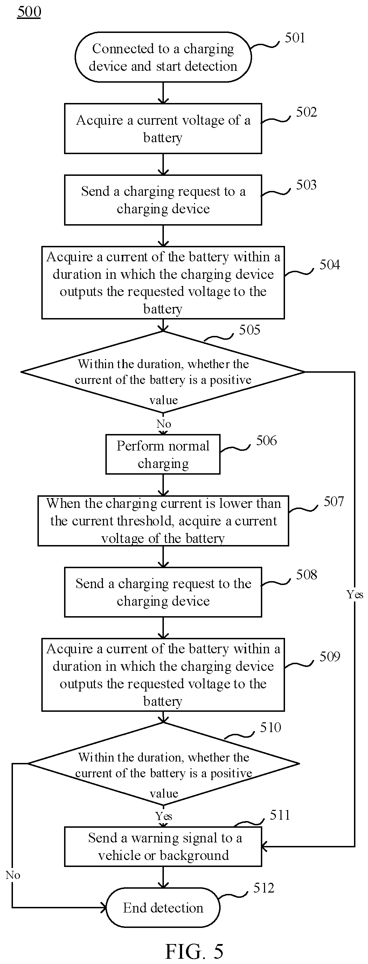

FIG. 5 is a schematic flow chart of one possible implementation of a detection method of an internal short circuit in a battery according to an embodiment of the present application. The detection of the internal short circuit condition in the battery 121 is realized by detecting the current variation of the battery 121. Reference may be made to the foregoing embodiments for similar steps in FIG. 5, and for the sake of brevity, details are not repeated here.

Step 501: a charging device 110 is connected to a battery 121, and detection starts.

When the charging device 110 is just connected to the battery 121 and has not yet in a charging stage, a current and voltage of the battery 121 are relatively stable. At this time, the detection of an internal short circuit condition in the battery 121 is started.

Step 502: acquire a current voltage V0 of the battery 121.

Step 503: send a charging request to the charging device 110.

The charging request includes a requested voltage V1 that is lower than the current voltage V0 of the battery 121 and a duration T of the requested voltage.

Step 504: acquire a current of the battery 121 within a duration T in which the charging device 110 outputs the requested voltage V1 to the battery 121.

Step 505: within the duration T, determine whether the current of the battery 121 is a positive value. When the current of the battery 121 is not a positive value, it is determined that the battery 121 does not have an internal short circuit, and the process proceeds to step 506; and when the current of the battery 121 is a positive value, it is determined that the battery 121 has an internal short circuit, and the process proceeds to step 511.

Step 506: perform normal charging.

After it is determined that the battery 121 does not have an internal short circuit, the battery 121 may be normally charged according to the normal charging steps and settings.

Step 507: when the charging current is lower than the current threshold, acquire a current voltage V0' of the battery 121.

During charging and/or when the charging is about to end, an internal short circuit condition of the battery 121 may be detected again in a case where the charging current is lower than the current threshold.

Step 508: send a charging request to the charging device 110.

The charging request includes a requested voltage V1' that is lower than the current voltage V0' of the battery 121 and a duration T' of the requested voltage.

Step 509: acquire a current of the battery 121 within the duration T in which the charging device 110 outputs the requested voltage V1' to the battery 121.

Step 510: within the duration T, determine whether the current of the battery 121 is a positive value. When the current of the battery 121 is not a positive value, it is determined that the battery 121 does not have an internal short circuit, and the process proceeds to step 512; and when the current of the battery 121 is a positive value, it is determined that the battery 121 has an internal short circuit, and the process proceeds to step 511.

Step 511: send a warning signal to a vehicle or background.

When an internal short circuit is detected in the battery, a warning signal is sent to the vehicle or the background to stop charging the battery 121, and the user is prompted to replace the battery 121 in time so as to avoid safety accidents in the subsequent process of using the vehicle.

Step 512: end the detection.

It can be seen from the foregoing detection method that by only detecting whether a positive value appears in the current of the battery within the duration of the requested voltage, whether the battery has an internal short circuit can be easily and accurately determined, thereby improving the safety of the battery. This detection method may be performed before and during charging, to further improve the accuracy of the detection result, perform warning in time, and avoid safety accidents.

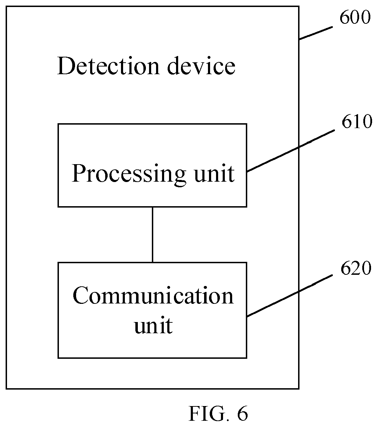

An embodiment of the present application further provides a detection device of an internal short circuit in a battery, as shown in FIG. 6. The detection method in the foregoing embodiments can be performed by a detection device 600 of an internal short circuit in a battery shown in FIG. 6. Accordingly, for parts not described in detail in the following embodiments, reference may be made to the foregoing embodiments.

The detection device 600 of the internal short circuit in the battery includes a processing unit 610 and a communication unit 620. The processing unit 610 is configured to acquire a current voltage of the battery; the communication unit 620 is configured to send a charging request to a charging device; the processing unit 610 is further configured to acquire a current of the battery within a duration in which the charging device outputs the requested voltage to the battery; and the processing unit 610 is further configured to determine an internal short circuit condition of the battery according to the current.

An embodiment of the present application further provides a battery management system, including a processor and a memory, the memory is configured to store a computer program, and the processor is configured to call the computer program to perform the foregoing detection method of the internal short circuit in the battery in the embodiments of the present application.

An embodiment of the present application further provides a readable storage medium, configured to store a computer program, and the computer program is configured to perform the detection method of the foregoing possible implementation.

Although the present application has been described with reference to the preferred embodiments thereof, various modifications can be made thereto without departing from the scope of the present application, and the components therein can be replaced with equivalents. In particular, each technical feature mentioned in each embodiment may be combined in any manner, as long as there is no structural conflict. The present application is not limited to the specific embodiments disclosed herein, and includes all technical solutions falling within the scope of the claims.

## Claims

1. A detection method for a battery, comprising:
acquiring a current voltage of the battery;
sending a charging request to a charging device, the charging request including a requested voltage, the charging request being used to request the charging device to output the requested voltage to the battery, wherein the requested voltage is smaller than the current voltage;
acquiring a current of the battery within a duration in which the charging device outputs the requested voltage to the battery; and
determining an internal short circuit condition of the battery according to the current.

2. The detection method according to claim 1, wherein the charging request further includes the duration.

3. The detection method according to claim 1 or 2, wherein the determining the internal short circuit condition of the battery according to the current comprises:
determining that the battery does not have an internal short circuit when the current is not a positive value at the end of the duration; or
determining that the battery has an internal short circuit when the current of the battery is a positive value within the duration.

4. The detecting method according to any one of claims 1 to 3, wherein the requested voltage is smaller than the current voltage by 0.1 to 100 millivolts.

5. The detection method according to any one of claims 1 to 4, wherein a range of the duration is 0.1 minutes to 60 minutes.

6. The detection method according to any one of claims 1 to 5, wherein the acquiring the current voltage of the battery comprises:
acquiring the current voltage of the battery when the battery is in a state of being connected to a charging device.

7. The detection method according to any one of claims 1 to 5, wherein the acquiring the current voltage of the battery comprises:
acquiring, in a process of charging the battery, the current voltage of the battery when the charging current is smaller than a current threshold.

8. A detection device for a battery, wherein the detection device comprises:
a processing unit, configured to acquire a current voltage of the battery;
a communication unit, configured to send a charging request to a charging device, the charging request including a requested voltage, the charging request being used to request the charging device to output the requested voltage to the battery, wherein the requested voltage is smaller than the current voltage;
wherein the processing unit is further configured to acquire a current of the battery within a duration in which the charging device outputs the requested voltage to the battery; and
the processing unit is further configured to determine an internal short circuit condition of the battery according to the current.

9. The detection device according to claim 8, wherein the charging request further includes the duration.

10. The detection device according to claim 8 or 9, wherein the processing unit is configured to:
determine that the battery does not have an internal short circuit when the current is not a positive value at the end of the duration; or
determine that the battery has an internal short circuit when the current is a positive value within the duration.

11. The detection device according to any one of claims 8 to 10, wherein the requested voltage is smaller than the current voltage by 0.1 to 100 millivolts.

12. The detection device according to any one of claims 8 to 11, wherein a range of the duration is 0.1 minutes to 60 minutes.

13. The detection device according to any one of claims 8 to 12, wherein the processing unit is configured to:
acquire the current voltage of the battery when the battery is in a state of just being connected to a charging device.

14. The detection device according to any one of claims 8 to 13, wherein
the processing unit is configured to:
acquire, in a process of charging the battery, the current voltage of the battery when the charging current is smaller than a current threshold.

15. A battery management system, comprising a processor and a memory, wherein the memory is configured to store a computer program, and the processor is configured to call the computer program to perform the detection method according to any one of claims 1 to 7.

16. A readable storage medium, configured to store a computer program, wherein the computer program is configured to perform the detection method according to any one of claims 1 to 7.
